Europäisches Patentamt

European Patent Office

Office européen des brevets

(19)

(11) **EP 0 632 930 B1**

(12) **EUROPÄISCHE PATENTSCHRIFT**

(45) Veröffentlichungstag und Bekanntmachung des Hinweises auf die Patenterteilung:
**22.07.1998 Patentblatt 1998/30**

(21) Anmeldenummer: **93906435.8**

(22) Anmeldetag: **23.03.1993**

(51) Int Cl.⁶: **H01L 27/146**

(86) Internationale Anmeldenummer:
**PCT/DE93/00267**

(87) Internationale Veröffentlichungsnummer:
**WO 93/19489 (30.09.1993 Gazette 1993/24)**

(54) **BILDZELLE INSBESONDERE FÜR EINEN BILDAUFNEHMER-CHIP**

IMAGE CELL, IN PARTICULAR FOR AN IMAGING CHIP

CELLULE D'IMAGE NOTAMMENT POUR UNE PUCE DE PRISE D'IMAGES

(84) Benannte Vertragsstaaten:
**AT BE CH DE DK ES FR GB GR IE IT LI LU MC NL PT SE**

(30) Priorität: **24.03.1992 DE 4209536**

(43) Veröffentlichungstag der Anmeldung:
**11.01.1995 Patentblatt 1995/02**

(73) Patentinhaber: **INSTITUT FÜR MIKROELEKTRONIK STUTTGART 70569 Stuttgart (DE)**

(72) Erfinder:
- **HÖFFLINGER, Bernd**
  **D-7032 Sindelfingen (DE)**
- **LANDGRAF, Marc**
  **Folsom, CA 95630 (US)**
- **SEGER, Ulrich**
  **D-7037 Magstadt (DE)**

(74) Vertreter: **Münich, Wilhelm, Dr.
Kanzlei Münich, Steinmann, Schiller
Wilhelm-Mayr-Str. 11
80689 München (DE)**

(56) Entgegenhaltungen:
**EP-A- 0 028 960        US-A- 4 473 836**

- **1985 CHAPEL HILL CONFERENCE ON VLSI 1985, Seiten 463 - 471 CARVER MEAD 'A SENSITIVE ELECTRONIC PHOTORECEPTOR'**
- **PATENT ABSTRACTS OF JAPAN vol. 15, no. 453 (E-1134)18. November 1991 & JP,A,3 192 764 ( MINOLTA CAMERA CO LTD )**
- **IEEE JOURNAL OF SOLID-STATE CIRCUITS Bd. 26, Nr. 3, März 1991, NEW YORK, USA Seiten 184 - 190 ANDREW GRUSS ET AL. 'INTEGRATED SENSOR AND RANGE-FINDING ANALOG SIGNAL PROCESSOR'**

## Beschreibung

## Technisches Gebiet

Die Erfindung bezieht sich auf eine Bildzelle für einen Bildaufnehmer-Chip mit einer Vielzahl derartiger in Form eines zweidimensionalen Arrays angeordneter Bildzellen und mit einer Ausleselogik, die zur Abbildung einer hohen Eingangssignaldynamik auf eine reduzierte Ausgangssignaldynamik ausgelegt ist.

Natürliche Szenen weisen eine Bestrahlungsstärke-Dynamik von unter Umständen mehr als 1.000.000:1 auf. Um derartige Szenen mit einem Bildaufnahmesystem gleichzeitig abbilden zu können, müßte jedes Glied in der Signalverarbeitungskette, d.h. das Sensorelement, die Ausleselogik, sowie ggf. nachgeordnete A/D-Konverter zum Einlesen des Bildes in ein Bildverarbeitungssystem einen Dynamikbereich von 120 dB aufweisen. Ein derartiger Dynamikbereich ist zwar mit einzelnen Komponenten, wie speziellen Halbleiterdioden oder diskreten A/D-Konvertern erreichbar, Elemente, die einen Dynamikbereich von 120 dB aufweisen, eignen sich jedoch nicht zur Integration in einem digitalen CMOS-Prozeß. Andererseits ist auf der digitalen "Seite", d.h bei der nachgeordneten Bildverarbeitung bei entsprechendem Hardware-Aufwand eine nahezu beliebige Dynamik erreichbar.

## Stand der Technik

In der US-PS 4 973 833 ist ein Bildaufnehmer-Chip vorgeschlagen worden, dessen lichtempfindliche Elemente Photodioden oder MOS-Transistoren sind, deren erzeugte Signale alle logarithmisch konvertiert werden. Zur Speicherung und zum Transfer der Signale der lichtempfindlichen Elemente wird ein Charge Coupled Device (CCD) verwandt.

Dieser aus der US-PS 4 973 833 bekannte Bildaufnehmer-Chip hat jedoch den Nachteil, daß es nicht möglich ist, die Eingangssignaldynamik zu steuern, die Eingangssignaldynamik ist vielmehr bei dem in der US-PS 4 973 833 beschriebenen Bildaufnehmer auf "logarithmisch" festgelegt. Ferner ist kein direktes und zerstörungsfreies Auslesen der Bildinformation möglich.

In der EP 0 390 205 A2 ist eine elektrische Schaltung beschrieben, die sich durch eine hohe Verstärkung bei der Umwandlung von elektrischer Ladung zu Spannung auszeichnet. Diese Schaltung wird vornehmlich für Charge Coupled Devices (CCDs) benutzt. Bei dieser in der EP 0 390 205 A2 beschriebenen Schaltung ist ebenfalls keine Steuerung der Kompression des Eingangssignals möglich. Die Verstärkerschaltung nach dem EP 0 390 205 A2 ermöglicht zwar eine hohe Verstärkung für geringe Ladungen, kann aber den Verstärkungsfaktor nicht steuern und wird bei höheren Ladungen schnell an ihre Grenzen stoßen.

In der US-PS 4 473 836 ist ein Bildaufnehmer-Chip vorgeschlagen worden, bei dem ein MOS-Feldeffekt-Transistor das lichtempfindliche Element bildet. Die Gate-Elektrode des MOS-Feldeffekt-Transistors ist elektrisch mit einem floatenden photoempfindlichen Diffusionsbereich verbunden. Hierdurch erhält man eine Bildzelle, die eine hohe Eingangssignaldynamik auf eine reduzierte Ausgangssignaldynamik abbildet. Diese Zelle erlaubt eine weitere Signalverarbeitung mit herkömmlichen, in dem selben MOS-Prozeß hergestellten Schaltungen, da stark reduzierte Dynamikanforderungen an diese Komponenten gestellt werden.

Dieser aus der US-PS 4 473 836 bekannte Bildaufnehmer-Chip hat jedoch eine Reihe von Nachteilen:

Zum einen erfolgt die Abbildung der Eingangssignaldynamik auf die Ausgangssignaldynamik nur annähernd logarithmisch, wobei der genaue Verlauf der Kennlinie stark von Herstell-Parametern abhängt. Dabei geht die ansatzweise logarithmische Kennlinie in eine "Wurzel-Kennlinie" über. Weiter werden Versorgungsspannungen benötigt, die nicht zu Versorgungsspannungen digitaler CMOS-VLSI Schaltungen kompatibel sind.

Weiterhin eignet sich der bekannte Bildaufnehmer mit ansatzweiser logarithmischer Signalkompression aufgrund von Intoleranzen gegenüber Schwankungen von Prozessparametern nicht für eine Array-Anordnung oder muß in Spezialprozessen hergestellt werden.

## Beschreibung der Erfindung

Der Erfindung liegt die Aufgabe zugrunde, eine Bildzelle insbesondere für einen Bildsensor anzugeben, die eine hohe Eingangssignaldynamik mit einer in bestimmten Grenzen wählbaren Kennlinie und insbesondere logarithmisch auf eine Ausgangssignaldynamik abbildet.

Diese Bildzelle und damit ein entsprechender Bildsensor soll bevorzugt in herkömmlicher CMOS-Technologie herstellbar und mit digitalen Schaltungsteilen integrierbar sowie mit einer einzigen Spannungsversorgung betreibbar sein, die zu herkömmlichen digitalen CMOS-Schaltungen kompatibel ist.

Ferner sollte der erfindungsgemäße Bildsensor die Realisierung einer rauscharmen Signalverstärkung sowie die Unterdrückung des Taktübersprechens beim Auslesen erlauben. Weiter soll es möglich sein, Bildpunkte mit hoher Pixelwiederholfrequenz (>>50Hz wie in HDTV-Anwendungen üblich) und möglichst im wahlfreien Zugriff, auszulesen.

Eine erfindungsgemäße Lösung dieser Aufgabe ist in den Patentansprüchen angegeben.

Erfindungsgemäß ist zur Abbildung einer hohen Eingangssignaldynamik auf eine reduzierte Ausgangssignaldynamik das lichtempfindliche Element der Bildzelle mit der einen Hauptelektrode eines ersten MOS-Transistors und mit dem Gate eines zweiten MOS-Transistors verbunden. An das Gate des ersten MOS-Transistors ist ein festes Potential ($V_{ss}$) angelegt, durch das die Kompression der Eingangssignaldynamik zu einer logarithmischen Ausgangskennlinie führt. Überdies sind die andere Hauptelektrode und das Gate der ersten MOS-Transistors (M1) kurzgeschlossen, wobei die andere Hauptelektrode des ersten MOS-Transistors (M1) und die erste Hauptelektrode des zweiten MOS-Transistors auf einem gemeinsamen Potential ($V_{ss}$) liegen. Schließlich ist an der zweiten Elektrode des zweiten MOS-Transistors ein Ausgangssignalverstärker angeschlossen.

Dabei ist bevorzugt die eine Hauptelektrode des ersten MOS-Transistors die Sourceelektrode und die andere Elektrode die Drainelektrode.

Die erfindungsgemäße Bildzelle weist eine Kennlinie "Beleuchtungsstärke bzw. Bestrahlungsstärke/Ausgangssignal" auf, die in bestimmten Grenzen eingestellt werden kann.

Erfindungsgemäß erhält man, wenn die Drainelektrode und das Gate des ersten MOS-Transistors kurzgeschlossen und auf ein festes Potential gelegt sind, eine über einen Bereich von mehr als sieben Dekaden exakt logarithmische Ausgangskennlinie, die eine radiometrisch eindeutige Auswertung der Bildinformation zuläßt.

Die erfindungsgemäße Bildzelle hat darüberhinaus eine Reihe weiterer Vorteile:

Beispielsweise läßt sich die Bildzelle und damit der erfindungsgemäße Bildsensor mit nahezu beliebigen Prozessen herstellen, wie der Aufzucht von Zellkulturen als Sensorelemente auf einem passivierten Chip, der als "Anschluß" nur noch über eine nach oben kontaktierbare Elektrode zur Ableitung der Potentiale dient.

Auch die Ankopplung von Schottky-Dioden als Sensorelemente insbesondere für den Infrarotbereich ist möglich. Außerdem sind Dioden, die auf elektromagnetische Strahlung empfindlich sind (insbesondere lichtempfindliche Dioden) als Sensorelemente denkbar.

Bei einer weiteren, für Bildsensoren für den sichtbaren Spektralbereich bevorzugten Ausführungsform ist das lichtempfindliche Element die eine Hauptelektrode des ersten MOS-Transistors.

Gerade in diesem Falle läßt sich der erfindungsgemäße Bildsensor in einem Standard CMOS-Prozeß für Digitalschaltungen - wie einem Prozess mit zwei Metallschichten und einer Polysiliziumschicht - sowohl in einem 2μm n- oder p-Wannen Prozeß als auch in einem 1,2 μm p- oder n-Wannen Prozeß (und noch kleineren Kanalbreiten) realisieren. Der erfindungsgemäße Bildsensor läßt sich dann auch mit Standard-CMOS-Versorgungspegeln betreiben.

Durch den erfindungsgemäßen Aufbau ist die Bild-Information ohne Zerstörung der Bildinformation auslesbar. Damit ist es möglich, die Ausleselogik so zu gestalten, daß sie einen wahlfreien Zugriff auf die einzelnen Bildzellen erlaubt. Dies ist insbesondere dann von Vorteil, wenn das aufgenommene Bild in einer Bildverarbeitungseinrichtung weiter verarbeitet werden soll, da es häufig ausreicht, zur Überprüfung einer Szene nur einen Teil der Bildzellen auszulesen. In diesem Falle ist es bevorzugt, wenn eine nachgeordnete Bildverarbeitungseinrichtung das Auslesen frei wählbarer Zellen über einen Bus und die Ausleselogik steuert.

Weiterhin ist es bevorzugt, wenn jede einzelne Bildzelle bzw. jedes Sensorelement über geeignete Treiber verfügt, die die Ansteuerung einer parasitären kapazitiven Last, z.B. einer Leseleitung erlauben. Diese Treiber können jeweils nur zum Zugriff aktiviert werden, um Energie einzusparen und die Sensorumgebung nicht aufzuheizen, bzw. das thermische Rauschen zu verringern.

Ebenso kann ein als Source-Folger-Verstärker ausgebildeter Ausleseverstärker vorgesehen werden, wobei bevorzugt der Treiber zweistufig ausgeführt wird.

Hierdurch erhält man eine schnelle Antwortzeit auf die (wahlfreie) Adressierung, ohne das Sensorelement mit einer hohen Eingangsimpedanz zu belasten. Ein geeigneter Ruhestrom in der ersten Stufe wird durch die Beschaltung erzwungen, so daß die Aussteuerung der zweiten (Leistungsstufe) in ausreichender Geschwindigkeit ermöglicht wird. Gegenüber herkömmlichen Sensorstrukturen können damit Arrays mit erheblich geringerer Stromaufnahme gebaut werden. Typische Werte sind 100 mW für ein 4096 Pixel großes Array incl. Dekoder.

Weiterhin ist selbst im "worst case", d.h. einer Bestrahlungsstärke <1μW/cm$^2$ eine Pixelwiederholfrequenz von 1kHz möglich.

Durch eine Weiterbildung der Bildzelle, bei der die Metallschicht, die die Bereiche, die nicht lichtempfindlich sein sollen, abdeckt, als Versorgungsleitung für die Schaltung verwendet wird, wird nicht nur der Herstellvorgang vereinfacht, sondern auch die Spannungsversorgung verbessert.

## Kurze Beschreibung der Zeichnung

Die Erfindung wird nachstehend ohne Beschränkung des allgemeinen Erfindungsgedankens anhand von Ausführungsbeispielen unter Bezugnahme auf die Zeichnung exemplarisch beschrieben, auf die im übrigen bezüglich der Offenbarung aller im Text nicht näher erläuterten erfindungsgemäßen Einzelheiten ausdrücklich verwiesen wird. Es zeigen:

| Fig. 1 | einen Ausschnitt aus einem erfindungsgemäßen Bildaufnehmer-Array, |
| Fig. 2 | einen Querschnitt durch eine Bildzelle, |
| Fig. 3 | mit diesem Ausführungsbeispiel erhaltene Meßergebnisse, und |
| Fig. 4a und 4b | einen Vergleich eines erfindungsgemäßen Sensors mit einem herkömmlichen Sensor mit "linearer Empfindlichkeit". |

**Beschreibung von Ausführungsbeispielen**

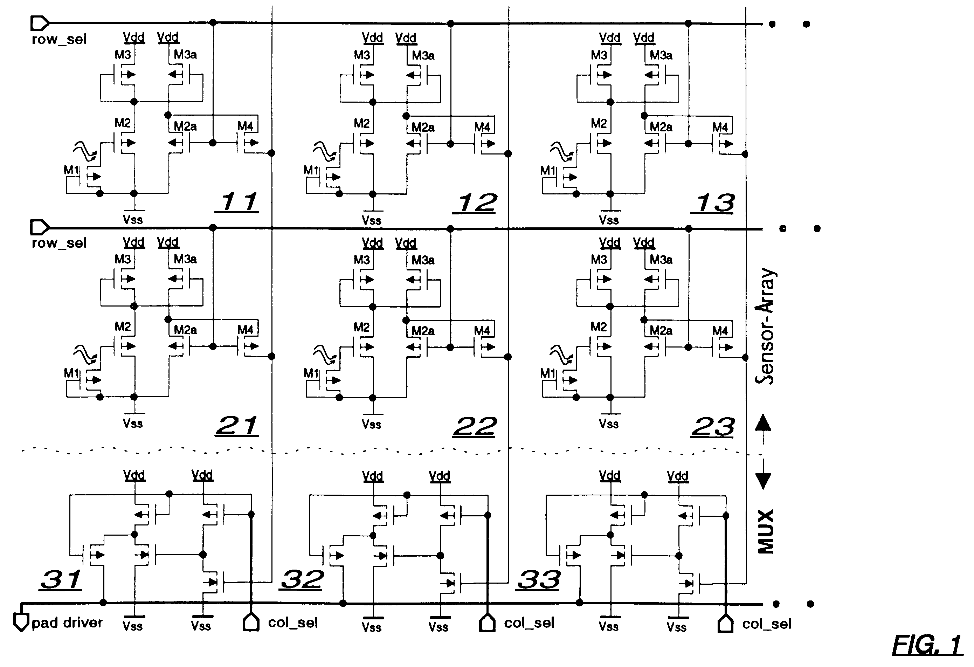

Fig. 1 zeigt einen Ausschnitt von 2*3 Bildzellen bzw. Sensorelementen 11..13, 21..23 aus einem Bildaufnehmer-Array. Im unteren Teil von Fig. 1 sind analoge Multiplexer 31, 32 und 33 mit digitalem Eingang dargestellt.

Bei dem gezeigten Ausführungsbeispiel besteht jede Bildzelle bzw. jedes Sensorelement 11..23 aus sechs MOS-Transistoren M1, M2, M2a, M3, M3a und M4, die beispielsweise p-Kanal Enhancement-Transistoren sein können. Das lichtempfindliche Element jeder Bildzelle 11..23 ist die Sourceelektrode des ersten MOS-Transistors M1, die mit dem Gate des zweiten MOS-Transistors M2 verbunden ist, der als Sourcefolger geschaltet ist. Die Drainelektrode des ersten MOS-Transistors M1 ist mit dem einen Pol $V_{ss}$ der Versorgungsspannungsquelle verbunden.

Der Sourcefolger M2 dient zur Impedanzwandlung und wird im Hinblick auf ein gutes Hochfrequenzverhalten unmittelbar neben dem Sensorelement, bei dem gezeigten Ausführungsbeispiel also dem Transistor M1 integriert.

Der MOS-Transistor M3 dient als "Load"-Element, d.h. als Last für den Sourcefolger M2.

Ein weiterer, ebenfalls als Sourcefolger geschalteter MOS-Transistor M3a bildet eine zweite Verstärkerstufe. Der MOS-Transistor M2a dient als Last für diese Verstärkerstufe, während der Ausgangstransistor M4 als Leistungstransistor geschaltet ist. Die MOS-Transistoren M2a und M4 werden nur während eines Auslesevorganges, bei dem die mit "row_sel" bezeichnete Steuerleitung für die Auswahl der auszulesenden Reihe aktiv auf niedriges Potential gelegt ist, durchgeschaltet, so daß sie auch nur während des Auslesevorganges Leistung aufnehmen.

Die Auswahl der auszulesenden Spalte (col_sel) erfolgt über die analogen Multiplexer 31..33, die über ein digitales Eingangssignal (col_sel) angesteuert werden. Zur genauen Ausbildung dieser Schaltungsbauteile wird ausdrücklich auf Fig. 1 verwiesen.

Die dargestellte Schaltung erlaubt eine rauscharme Verstärkung direkt am Sensorelement und eine Anpassung an gewünschte Arraygrößen, bzw. geforderte Auslesezeiten.

Bevorzugt sind bei der in Fig. 1 dargestellten Schaltung außer der photoaktiven Sourceelektrode des MOS-Transistors 1 alle Schaltungsteile mit einer Aluminium-Abschirmung abgedeckt, die gleichzeitig zur elektrischen Versorgung des Chips ($V_{ss}$) und zur Stabilisierung der Spannungsversorgung (Verwendung als Siebkondensator !) dient, und damit eine höhere Integrationsdichte erlaubt.

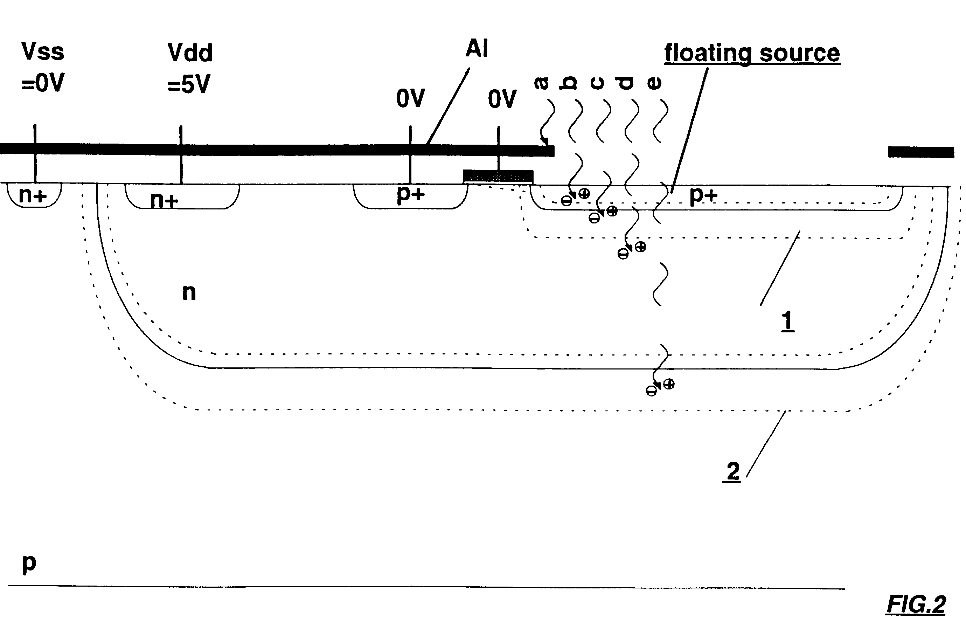

Fig. 2 zeigt eine mögliche Realisierung einer Bildzelle 11..23. Die Transistoren M1 bis M6 sind p-Kanal Enhancement-Transistoren in einer n-Wanne, die auf positives Versorgungspotential $V_{dd}$ (5V) gelegt ist, während das darunterliegende Substrat mit negativem Versorgungspotential $V_{ss}$ (OV) kontaktiert wird.

Natürlich ist entsprechend eine Bildzelle aus ausschließlich n-Kanal Enhancement Transistoren in einer p-Wanne, oder CMOS-Transistoren in mehreren Wannen, dann allerdings auf Kosten des Füllfaktors, realisierbar.

Wie bereits erwähnt, ist das eigentliche photoaktive Element die "floating source" des MOS-Transistors M1, da die restliche Schaltung durch eine Aluminium-Abschirmung Al abgedeckt ist, die verhindert, daß auf sie auftreffende Strahlungsteilchen (Fall a in Fig. 2) Ladungsträger im halbleitenden Material generieren.

Die "floating-source" sammelt "Löcher", die durch Lichteinwirkung in der n-Wanne generiert werden und durch Diffusions- oder Drift-Ströme (letzteres nur in geringem Umfang) in die Raumladungszone 1 gelangen, oder direkt in der Raumladungszone 1 generiert werden (Fall c und d in Fig. 2). Ladungen, die in Oberflächen-nahen Schichten der Sourceelektrode erzeugt werden, (Fall b) werden größtenteils in "surface traps" gefangen und tragen daher kaum zu dem erzeugten Photostrom bei Ladungen, die in der Raumladungszone 2 generiert werden, können über die Wanne bzw. das Substrat abgeleitet werden. Nur die Ladungsträger, welche in der Raumladungszone der Sourceelektrode gesammelt werden und die direkt proportional zur absorbierten Lichtenergie sind, tragen zur Potentialerhöhung bei, führen jedoch nicht zur Ausbildung einer Inversionsschicht im Kanal, da das Source-potential ständig unter der Schwellspannung bleibt, da die n-Wanne auf 5V liegt.

Im Gegensatz zu herkömmlichen integrierenden Photodetektoren werden in einer erfindungsgemäß aufgebauten Bildzelle die Ladungen in Form des "Subthreshold"-Stromes durch den Kanal abgeleitet; d.h., ist der ableitende Transistor richtig dimensioniert, kann selbst bei Bestrahlungen mit sichtbarem Licht in einem Bereich < 10W/cm$^2$ keine Sättigung auftreten.

Der "Subthreshold"-Strom, der letzlich das Source-Potential beeinflußt, läßt sich aus der folgenden Beziehung berechnen:

$$I_{ST} = (K_1 C_B)^* (kT/q)^2 {}^* e[q(\phi_{sS} -2\phi_F)/kT]^*(1 - e^{[(-qV_{DS})/kT]}) \tag{1}$$

$$C_B = (K_2/[2(\phi_{sS} - V_{BS})])^{1/2} \tag{2}$$

$$\phi_{sS} = V_{GS} - V_{FB} - V_0[1 + 2(V_{GS} - V_{VB} - V_{BS})]^{1/2} \tag{3}$$

wobei

$K_1 =$     $\mu_{neff}$ W/L
         mit $\mu_{n\_eff}$ = effektive Elektronenbeweglichkeit
$K_2 =$     $qK_s \in_o N_B$ mit

     $K_s =$     dielektrische Konstante von Si
     $N_B =$     Netto Dotierstoffkonzentration

$C_B =$     Kapazität der Verarmungszone ($F/cm^2$)
$k =$     Boltzmannkonstante
$T =$     Temperatur in Kelvin
$q =$     Elementarladung
$\phi_{F2} =$     Fermipotential
$\phi_{sS} =$     Oberflächen-Potential der Source
$V_0 =$     $qK_s \in_o N_B/(C_o)^2$ mit

     $C_o =$     flächen-normierte Oxidkapazität ($F/cm^2$)

$V_{FB} =$     Flachband-Spannung
$V_{DS} =$     Drain Source-Spannung
$V_{BS} =$     Bulk Source-Spannung
$V_{GS} =$     Gate Source-Spannung

Der zweite exponentielle Faktor in Gl. (1) kann für $V_{DS} > kT/q$ vernachlässigt werden.

Wegen der in Fig. 1 dargestellten Beschaltung des Sensorelements ist $V_{GS}$-$V_{BS}$ von $V_S$ unabhängig; d.h. eine Konstante. Damit hängt $\phi_{sS}$ in Gl. (3) direkt von $V_{GS}$ ab und führt bei Einsetzen in Gl. (2) zu einer weiteren Konstanten. Erneutes Einsetzen in Gl. (1) zeigt, daß für $I_{ST}$ eine rein exponentielle Abhängigkeit von $V_S$ besteht; d.h. daß der Photostrom dem Logarithmus der Sourcespannung und damit der eingestrahlten Lichtleistung proportional ist. In bisher bekannten, ähnlichen Strukturen (1) führt die Anbindung der Source auf das Gate zu einer zusätzlichen Quadratwurzelabhängigkeit in der Gleichungen (2) und (3).

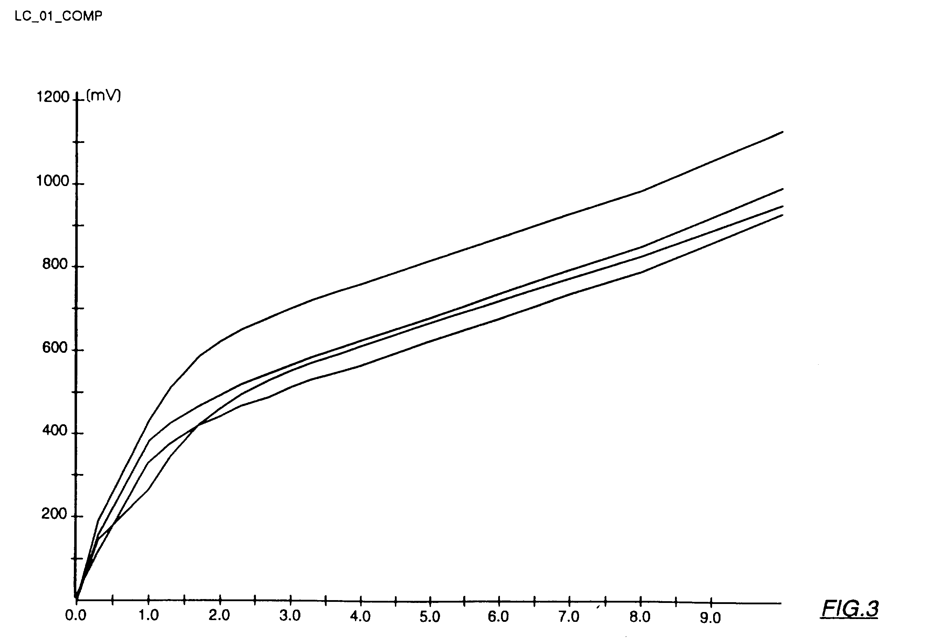

Fig. 3 zeigt die Abhängigkeit der Ausgangsspannung in mV als Funktion der Bestrahlungsstärke, wobei diese auf der Abszisse in willkürlichen Einheiten von $10^x$ aufgetragen ist. Fig. 3 zeigt. daß über einen Bereich von sieben Dekaden eine exakte Lin-Log Umsetzung erfolgt.

Fig. 4a zeigt im oberen Teil das Ausgangssignal einer erfindungsgemäßen Bildzelle als Funktion der auf der Abszisse aufgetragenen Beleuchtungsstärke. Dabei verdoppelt sich die Intensität des auf die Bildzelle auftreffenden Lichts bei jedem Schritt in x-Richtung. Das entsprechende Ausgangssignal der Bildzelle mit logarithmischer Kennlinie ist auf der y-Achse in willkürlichen Einheiten aufgetragen.

Fig. 4b zeigt die entsprechenden Darstellungen für eine herkömmliche Bildzelle mit "linearer Empfindlichkeit".

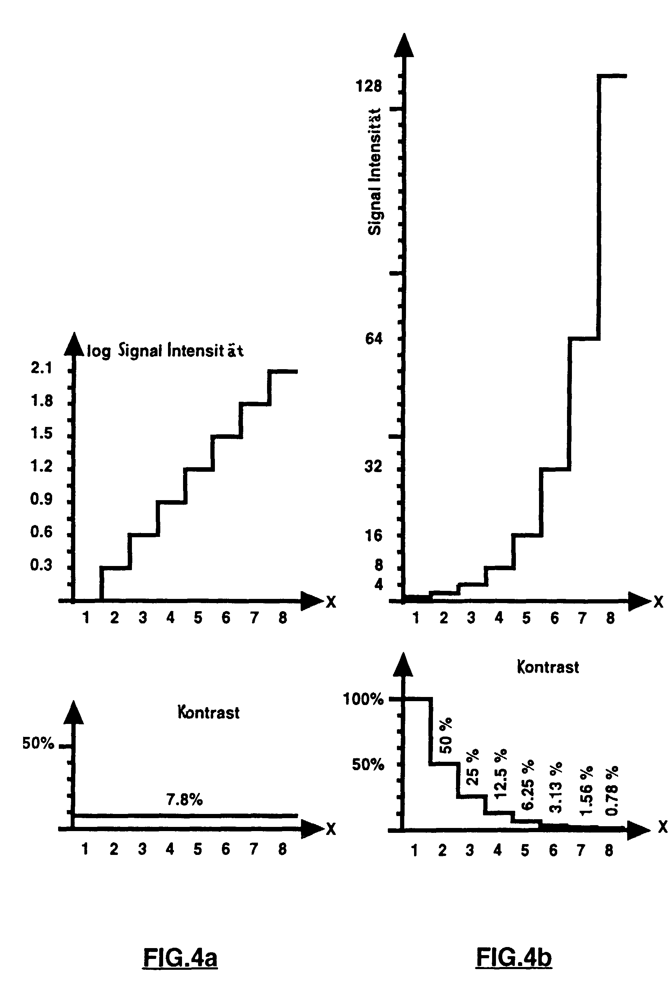

Im unteren Teil der Fig. 4a und 4b ist der auflösbare Kontrast für die jeweiligen Bildzellen bei A/D-Wandlung mit einem 8-bit-A/D-Wandler aufgetragen. Für die erfindungsgemäße Bildzelle ist der auflösbare Kontrast unabhängig von der Beleuchtungsstärke konstant, während er bei herkömmlichen Bildzellen mit zunehmender Intensität sinkt und auf geringe Werte zurückgeht.

Die erfindungsgemäßen Bildzellen bzw. Sensorelemente erlauben die exakt logarithmische Kompression von Lichtsignalen und eignen sich daher besonders zur Abbildung hochdynamischer Lichtsignale. Die Integration von Sensorelementen und Ausleseverstärker in eine Bildzelle, die in Standard CMOS Prozessen (sowohl p- als auch n-Wannen tauglich) prozessierbar ist, qualifiziert dieser Bildsensorzelle besonders für den Bau von XY-Bildsensoren mit integrierter digitaler Bildverarbeitung.

Die erfindungsgemäße Bildzelle eignet sich aber auch als "stand-alone"-Element, beispielsweise als lichtempfindliches Element zum Einsatz in Repeatern für Lichtwellenleiter.

**Patentansprüche**

1. Bildzelle für einen Bildaufnehmer-Chip mit einer Vielzahl derartiger in Form eines zweidimensionalen Arrays angeordneter Bildzellen und mit einer Ausleselogik, die zur Abbildung einer hohen Eingangssignaldynamik auf eine reduzierte Ausgangssignaldynamik ausgelegt ist,
   wobei das lichtempfindliche Element der Bildzelle (11..23) zwischen die eine Hauptelektrode eines ersten MOS-Transistors (M1) und das Gate eines zweiten MOS-Transistors (M2) geschaltet und jeweils direkt verbunden ist,
   dadurch **gekennzeichnet,**

   - daß an das Gate des ersten MOS-Transistors (M1) ein festes Potential ($V_{ss}$) angelegt ist, durch das die Kompression der Eingangssignaldynamik zu einer logarithmischen Ausgangskennlinie führt,

   - daß die andere Hauptelektrode und das Gate des ersten MOS-Transistors (M1) kurzgeschlossen sind,

   - daß die andere Hauptelektrode des ersten MOS-Transistors (M1) und die erste Hauptelektrode des zweiten MOS-Transistors auf einem gemeinsamen Potential ($V_{ss}$) liegen, und

   - daß an der zweiten Elektrode des zweiten MOS-Transistors (M2) ein Ausgangssignalverstärker angeschlossen ist.

2. Bildzelle nach Anspruch 1,
   dadurch **gekennzeichnet,** daß die eine Hauptelektrode des ersten MOS-Transistors (M1) die Sourceelektrode und die andere Hauptelektrode die Drainelektrode ist.

3. Bildzelle nach Anspruch 1 oder 2,
   dadurch **gekennzeichnet,** daß das lichtempfindliche Element die eine Hauptelektrode des ersten MOS-Transistors (M1) ist.

4. Bildzelle nach einem der Ansprüche 1 bis 3,
   dadurch **gekennzeichnet**, daß die zweite Hauptelektrode des zweiten MOS-Transistors die Sourceelektrode ist.

5. Bildzelle nach einem der Ansprüche 1 bis 4,
   dadurch **gekennzeichnet,** daß der Ausgangssignalverstärker ein zweistufig ausgebildeter weiterer Verstärker (M3a, M4) ist, dessen erste Stufe (M3a) einen geringen Ruhestrom aufnimmt, und dessen zweite als Leistungsstufe ausgebildete Stufe (M4) nur zum Auslesen aktiviert wird.

6. Bildzelle nach Anspruch 4,
   dadurch **gekennzeichnet,** daß ein MOS-Transistor (M3) als Last für den zweiten MOS-Transistor dient.

**Claims**

1. An image cell for an image-recorder chip having a multiplicity of such image cells disposed in the form of a two dimensional array and having a readout logic, which is designed for forming a high input signal dynamic on a reduced output signal dynamic, with the light-sensitive element of the image cell (11..23) being in a circuit between the one main electrode of a first MOS transistor (M1) and the gate of a second MOS transistor (M2) and being directly connected thereto respectively,
   **characterized by**

   - a fixed potential ($V_{ss}$) being applied to the gate of said first MOS transistor (M1) by means of which the compression of the input signal dynamic leads to an output logarithmic line,
   - the other main electrode and said gate of said first MOS transistor (M1) being short circuited,
   - said other main electrode of said first transistor (M1) and the first main electrode of said second transistor lying on a common potential ($V_{ss}$), and

- an output singal amplifier being connected to the second electrode of said second MOS transistor (M2).

2. An image cell according to claim 1,
   **characterized by** said one main electrode of said first MOS transistor (M1) being the source electrode and the other electrode the drain electrode.

3. An image cell according to claim 1 or 2,
   **characterized by** said light-sensitive element being said one main electrode of said first MOS transistor (M1).

4. An image cell according to one of the claims 1 to 3,
   **characterized by** said second main electrode of said second MOS transistor being the source electrode.

5. An image cell according to one of the claims 1 to 4,
   **characterized by** said output signal amplifier being a two-stage designed further amplifier (M3a, M4), the first stage of which (M3a) takes a small quiescent current and its second stage (M4) designed as a power stage (M4) only becomes activated for reading out.

6. An image cell according to claim 4,
   **characterized by** a MOS transistors (M3) serving as a load for said second MOS transistor.


## Revendications

1. Cellule d'image notamment pour une plaquette d'enregistrement d'images, comportant une multiplicité de telles cellules d'image disposées sous la forme d'un réseau bidimensionnel, et une logique de lecture, qui est conçue pour réaliser une application surjective d'une dynamique élevée du signal de sortie sur une dynamique réduite du signal de sortie,
   dans laquelle l'élément photosensible de la cellule d'image (11...23) est branché entre une première électrode principale d'un premier transistor MOS (M1) et la grille d'un deuxième transistor MOS (M2) et est relié respectivement directement à cette électrode principale et à cette grille,
   caractérisée en ce

   - qu'à la grille du premier transistor MOS (M1) est appliqué un potentiel fixe ($V_{SS}$), au moyen duquel la compression de la dynamique du signal d'entrée conduit à une courbe caractéristique de sortie logarithmique,
   - que l'autre électrode principale et la grille du premier transistor MOS (M1) sont court-circuitées,
   - que l'autre électrode principale du premier transistor MOS (M1) et la première électrode principale du deuxième transistor MOS sont placées à un potentiel commun ($V_{SS}$), et
   - qu'un amplificateur du signal de sortie est raccordé à la deuxième électrode du deuxième transistor MOS (M2).

2. Cellule d'image selon la revendication 1, caractérisée en ce que la première électrode principale du premier transistor MOS (M1) est l'électrode de source et l'autre électrode principale est l'électrode de drain.

3. Cellule d'image selon la revendication 1 ou 2, caractérisée en ce que l'élément photosensible est la première électrode principale du premier transistor MOS (M1).

4. Cellule d'image selon l'une des revendications 1 à 3, caractérisée en ce que la deuxième électrode principale du deuxième transistor MOS est l'électrode de source.

5. Cellule d'image selon l'une des revendications 1 à 4, caractérisée en ce que l'amplificateur du signal de sortie est un autre amplificateur (M3a, M4) réalisé à deux étages, dont le premier étage (M3a) reçoit un faible courant de repos et dont le deuxième étage (M4) est agencé sous la forme d'un étage de puissance et est activé uniquement pour la lecture.

6. Cellule d'image selon la revendication 4, caractérisée en ce qu'un transistor MOS (M3) est utilisé en tant que charge pour le deuxième transistor MOS.

FIG. 1

**FIG.2**

Vss =0V  Vdd =5V  Al  0V  0V  a b c d e  floating source

n+  n+  p+  p+

n

p

1

2

EP 0 632 930 B1

LC_01_COMP

1200 (mV)

1000

800

600

400

200

0.0   1.0   2.0   3.0   4.0   5.0   6.0   7.0   8.0   9.0

_FIG.3_

**FIG.4a**

**FIG.4b**